# EUROPÄISCHE PATENTSCHRIFT

(11) **EP 2 561 557 B1**
(45) Veröffentlichungstag und Bekanntmachung des Hinweises auf die Patenterteilung: **02.11.2016**
(21) Anmeldenummer: 11704452.9
(22) Anmeldetag: 21.02.2011
(51) Int. Cl.: H01L 31/18

(54) **VERFAHREN ZUR HERSTELLUNG EINER SOLARZELLE**
METHOD FOR PRODUCING A SOLAR CELL
PROCÉDÉ DE RÉALISATION D'UNE CELLULE SOLAIRE

(30) Priorität: 20.04.2010 DE 102010027940
(43) Veröffentlichungstag der Anmeldung: 27.02.2013
(73) Patentinhaber: Robert Bosch GmbH, 70442 Stuttgart (DE)
(72) Erfinder: KROKOSZINSKI, Hans-Joachim, 69226 Nussloch (DE)
(74) Vertreter: Isarpatent
(86) Internationale Anmeldenummer: PCT/EP2011/052503
(87) Internationale Veröffentlichungsnummer: WO 2011/131388

(56) Entgegenhaltungen:
- EP-A1- 1 906 455
- WO-A1-2009/101107
- DE-A1- 3 520 699
- DE-A1-102009 034 594
- JP-A- 2002 025 926
- US-A- 3 067 071
- GAZUZ V ET AL: "Thin (90um) multicrystalline Si solar cell with 15% efficiency by Al-bonding to glass", 23RD EUROPEAN PHOTOVOLTAIC SOLAR ENERGY CONFERENCE, EU PVSEC ; PROCEEDINGS OF THE INTERNATIONAL CONFERENCE, HELD IN VALENCIA, SPAIN, 1 - 5 SEPTEMBER 2008, WIP-RENEWABLE ENERGIES, 1. September 2008 (2008-09-01), Seiten 1040-1042, XP040528977, ISBN: 978-3-936338-24-9
- CUEVAS A ED - INSTITUTE OF ELECTRICAL AND ELECTRONICS ENGINEERS: "A good recipe to make silicon solar cells", PROCEEDINGS OF THE PHOTOVOLTAIC SPECIALISTS CONFERENCE. LAS VEGAS, OCT. 7 - 11, 1991; [PROCEEDINGS OF THE PHOTOVOLTAIC SPECIALISTS CONFERENCE], NEW YORK, IEEE, US, Bd. CONF. 22, 7. Oktober 1991 (1991-10-07) , Seiten 466-470, XP010039214, DOI: 10.1109/PVSC.1991.169259 ISBN: 978-0-87942-636-1
- RAUER M ET AL: "Passivation of screen-printed aluminium-alloyed emitters for back junction n-type silicon solar cells", 24ST EUROPEAN PHOTOVOLTAIC SOLAR ENERGY CONFERENCE, PROCEEDINGS OF THE 24ST INTERNATIONAL CONFERENCE, WIP-RENEWABLE ENERGIES, 21. September 2009 (2009-09-21), Seiten 1059-1062, XP040529884, ISBN: 978-3-936338-25-6

## Beschreibung

Die Erfindung betrifft ein Verfahren zur Herstellung einer Solarzelle.

### Stand der Technik

Silizium-Solarzellen werden häufig mit einer ganzflächigen Metallisierung zur Verspiegelung und zur Stromsammlung auf der Rückseite versehen. Diese Rückseitenmetallisierung besteht in der Regel aus Aluminium-basierter Dickschichtpaste, die großflächig zwischen Silber-basierten Lötflächen aufgedruckt wird. Beim Sintern oberhalb von 800°C legiert das Aluminium durch Bildung des niederschmelzenden (577°C) AlSi-Eutektikums und Rekristallisation an die Halbleiteroberfläche an und kompensiert dabei die vorhandene n⁺-Dotierung aus der vorher rundum erfolgten Phosphordiffusion zu einer stark p-dotierten (p⁺-)Dotierung über (siehe F. Huster, 20th European Photovoltaic Solar Energy Conference, 6-10 June 2005, Barcelona, Spain). Wenn die Basisdotierung p ist, bildet die Aluminium-dotierte rekristallisierte Oberflächenschicht ein p⁺-BSF (Back Surface Field) mit einem p⁺p-Übergang (high-low-Übergang) Die gleiche Zellstruktur wird seit einigen Jahren mit praktisch identischem Prozess auch auf n-dotiertem Silizium hergestellt. Dann wird die besagte Aluminium-dotierte Oberfläche der Rückseite zum p⁺-Emitter und die Phosphor-dotierte Schicht der Vorderseite zum Front Surface Field (FSF).

Nachteilig an den bisher bekannten Verfahren ist, dass die gedruckte Aluminium-Pastenschicht ca. 40 µm (nach dem Sintern) dick sein muss, um hinreichend tiefe Legierungsbildung bzw. Aluminium-Dotiertiefe zu erhalten. Aufgrund des Bimetalleffekts zwischen ihr und dem Siliziumwafer führt eine Verringerung der Waferdicke unter die bisher typischen 180 µm zu einer nicht mehr tolerierbaren Waferverbiegung (sogenanntem Bow). Durch die nötige Dicke des Siliziumwafers und der daher benötigten Menge an Silizium entstehen hohe Kosten für die Solarzelle.

Die Siebdruckmetallisierung der Rückseite hat einen nicht perfekten Reflexionsfaktor von nur 65% für die langwelligen Anteile des Sonnenlichts, die bis zur Rückseite durchdringen. Eine wirksamere Verspiegelung von >90% würde die optische Weglänge des einfallenden Lichts und damit die Generation von Elektron-Loch-Paaren (d.h. den Strom) im Innern der Zelle erhöhen. Damit würde ein deutlicher Wirkungsgradgewinn erzielt.

Eine metallische Oberfläche, sowohl die eines Emitters als auch die eines Back-Surface-Fields (BSF), hat trotz der Feldpassivierung durch Hochdotierung eine große Ladungsträger-Rekombinationsgeschwindigkeit. Um eine bessere Passivierung der Aluminium-dotierten Oberfläche der Rückseite zu ermöglichen, müssen die als Dotierquelle benötigte dicke Aluminium-Siebdruckschicht und die zwischen ihr und der Halbleiteroberfläche entstandene AlSi-Eutektikumsschicht abgeätzt werden. Dazu ist aufgrund der Dicke der abzuätzenden Schichten bei den vorbekannten Verfahren eine große Menge Salzsäure nötig, was ein großes Entsorgungsproblem darstellt.

### Offenbarung der Erfindung

Gegenstand der vorliegenden Erfindung ist ein Verfahren zur Herstellung einer Solarzelle wie in Anspruch 1 beansprucht.

Vorteilhaft an diesem Verfahren ist, dass technisch einfach und kostengünstig eine Solarzelle hergestellt wird, die eine Aluminiumdotierschicht auf der Rückseite aufweist und eine Passivierung der aluminiumdotierten Rückseite ermöglicht. Ein weiterer Vorteil hieran ist, dass die Aluminiumschicht vollflächig in direktem Kontakt zur zweiten Hauptoberfläche aufgebracht wird. Dadurch kann beim Aufschmelzen am eutektischen Punkt die gesamte Schichtmenge an Aluminium unmittelbar, d.h. unverzögert und/oder unbehindert, zur Schmelzenbildung verbraucht werden. Die Aluminium-Silizium-Verschmelzung läuft auf der gesamten zweiten Hauptoberfläche gleichmäßig ab. Zudem wird die Aluminiumschicht durch die Glasschicht vollständig abgedeckt, so dass beim Aufschmelzen des Aluminium-Silizium-Eutektikums an keiner Stelle die geschmolzene Schicht offenliegt, wodurch ein Zusammenlaufen zu Tropfen, ein Verspritzen und/oder Oxidieren weitgehend verhindert wird. Da die Glasschicht als vorübergehende Abdeckung der Aluminium-Dünnschicht gedacht ist und nach der Dotierung wieder entfernt wird, kann die Dicke möglichst dünn gewählt werden. Somit kann die Glasschicht einfacher bzw. schneller wieder entfernt werden. Vorteilhaft ist auch, dass die Glasschicht einen geringen Ausdehnungskoeffizienten aufweist, der dem Silizium des Silizium-Substrat ähnlich ist, wodurch eine Verbiegung des Silizium-Substrats weitgehend vermieden wird. Das Silizium-Substrat kann daher eine deutlich geringere Dicke aufweisen. Dies zusammen bewirkt, dass der Wirkungsgrad der Solarzelle erhöht wird und die Herstellungskosten der Solarzelle deutlich verringert werden.

Das Sintern kann bei einer Temperatur von mindestens 800 °C ablaufen. Hierdurch wird sichergestellt, dass die Aluminiumschicht zusammen mit dem Silizium eine flüssige Aluminium-Silizium-Eutektikumschicht bildet.

Bei dem Verfahren kann die Paste mittels Drucken, insbesondere mittels Siebdruck, aufgetragen werden. Hierdurch werden die Kosten des Verfahrens weiter gesenkt.

Bei einer Ausführungsform des Verfahrens wird die Glasschicht, insbesondere mittels Flusssäure, und die Aluminium-Silizium-Eutektikumschicht, insbesondere mittels Salzsäure, von der zweiten Hauptoberfläche weggeätzt. Vorteilhaft hieran ist, dass durch ein bewährtes Verfahren die Schichten gleichmäßig von der zweiten Hauptoberfläche entfernt werden. Zudem ist vorteilhaft, dass durch die geringe Dicke der Aluminium-Silizium-Eutektikumschicht weniger Salzsäure benötigt wird, was die Kosten und den Aufwand senkt, da die Entsorgung von Salzsäure sehr kostenträchtig und aufwändig ist.

Bei dem Verfahren können ferner Metallkontaktbahnen zum Kontaktieren des Silizium-Substrats und optional Sammelschienen zum elektrischen Verbinden der Metallkontaktbahnen auf die erste Hauptoberfläche aufgebracht werden, wobei während des Sinterns der Paste auf der zweiten Hauptoberfläche gleichzeitig die Metallkontaktbahnen und die optionalen Sammelschienen gesintert werden. Durch die Metallkontaktbahnen werden die Ladungen in der Nähe der ersten Hauptoberfläche gesammelt und durch optionale Sammelschienen werden die Ladungen mehrerer Metallkontaktbahnen gesammelt. Vorteilhaft ist zudem, dass durch das gemeinsame Sintern der Metallkontaktbahnen und der optionalen Sammelschienen und der Paste auf der zweiten Hauptoberfläche ein zusätzlicher Schritt eingespart wird, der zum Sintern der Metallkontaktbahnen und der optionalen Sammelschienen nötig wäre.

Die Metallkontaktbahnen und optionalen Sammelschienen können durch Aufdrucken einer Silberpaste und/oder Aufsprühen einer silberhaltigen Aerosol-Tinte und/oder Extrudieren einer Silberpaste aus feinen Kanülen aufgebracht werden. Durch diese kostengünstigen Verfahren zum Auftragen der Metallkontaktbahnen und optionalen Sammelschienen wird eine gleichmäßige Dicke der Metallkontaktbahnen und optionalen Sammelschienen sichergestellt.

Bei einer weiteren Ausführungsform des Verfahrens wird ferner vor dem Aufbringen der Paste auf die zweite Hauptoberfläche eine dünne dielektrische Schicht, insbesondere ein Oxid und/oder ein Nitrid umfassend, auf die Dünnschicht zur Vermeidung einer Oxidation des Aluminiums der Dünnschicht an Luft aufgebracht. Hierdurch wird sichergestellt, dass die Aluminium-Dünnschicht nicht oxidiert, was sich negativ auf die Erzeugung eines Aluminium-Eutektikums bzw. der Aluminiumdotierschicht auswirken würde.

Bei einer weiteren Ausführungsform des Verfahrens wird ferner nach dem Freilegen der Aluminiumdotierschicht eine Passivierungsschicht auf die zweite Hauptoberfläche aufgebracht, die Passivierungsschicht von Bereichen der zweiten Hauptoberfläche zum Bilden von Öffnungen entfernt, und eine weitere Aluminiumschicht, insbesondere durch ein PVD-Verfahren, vorzugsweise Sputtern und/oder Aufdampfen, auf die zweite Hauptoberfläche zum Kontaktieren der Aluminium-Dotierschicht in den Öffnungen aufgebracht. Durch die Passivierungsschicht wird der Wirkungsgrad der Solarzelle erhöht. Zudem ist vorteilhaft, dass auf technisch einfache Art und Weise die zweite Hauptoberfläche des Silizium-Substrats durch die weitere Aluminiumschicht kontaktiert wird. Darüber hinaus kann die Leerlaufspannung erhöht werden. Zudem bilden die Passivierungsschicht und die weitere Aluminiumschicht zusammen einen verbesserten Infrarotlichtspiegel auf der zweiten Hauptoberfläche gegenüber einer porösen Aluminium-Schicht, wodurch ein höherer Stromertrag pro Zelle erreicht wird.

Das Entfernen der Passivierungsschicht von Bereichen der zweiten Hauptoberfläche kann mittels Laserablation, Ätzpaste und/oder Ionenätzen geschehen. Hierdurch werden die Kosten und der Aufwand des Verfahrens weiter gesenkt, da bewährte Methoden zur Entfernung der Passivierungsschicht verwendet werden.

Bei dem Verfahren kann ferner eine nickelhaltige Grundschicht auf die weitere Aluminiumschicht der zweiten Hauptoberfläche aufgebracht werden zur Ermöglichung einer chemischen und/oder galvanischen Verstärkung. Hierdurch wird das Auftragen weiterer Schichten auf die zweite Hauptoberfläche wesentlich erleichtert.

Bei dem Verfahren kann ferner nach dem Aufbringen der Aluminiumschicht und der optionalen nickelhaltigen Schicht auf die zweite Hauptoberfläche eine Isolierungsschicht auf die zweite Hauptoberfläche aufgebracht werden, und die Isolierungsschicht von Bereichen der zweiten Hauptoberfläche zum erneuten Freilegen der Lötflächen, insbesondere durch Laserablation, Ätzpaste und/oder Ionenätzen, entfernt werden zur Ermöglichung einer nachträglichen chemischen und/oder galvanischen Verstärkung der Lötflächenöffnungen. Hierdurch wird sichergestellt, dass aufgebrachte Schichten zur Verstärkung auf die Lötflächenöffnungen beschränkt sind bzw. das Aufbringen weiterer Schichten nur auf die Lötflächenöffnungen deutlich erleichtert wird.

Bei dem Verfahren kann ferner eine lötfähige Schicht oder Schichtfolge, insbesondere Nickel, Silber, Kupfer und/oder Zinn umfassend, auf die Metallkontaktbahnen der ersten Hauptoberfläche und die Lötflächenöffnungen der zweiten Hauptoberfläche galvanisch und/oder chemisch aufgebracht werden, wobei ferner die Verstärkungsschicht der ersten Hauptoberfläche von der Schicht der zweiten Hauptoberfläche verschieden sein kann. Hierdurch werden Lötflächen hergestellt, die durch Löten einfach kontaktiert werden können, um die zweite Hauptoberfläche des Silizium-Substrats elektrisch zu kontaktieren.

### Zeichnungen

Weitere Vorteile und Zweckmäßigkeiten der Erfindung werden durch die Zeichnungen veranschaulicht und in der nachfolgenden Beschreibung erläutert. Dabei ist zu beachten, dass die Zeichnungen nur beschreibenden Charakter haben und nicht dazu gedacht sind, die Erfindung in irgendeiner Form einzuschränken. Es zeigen:

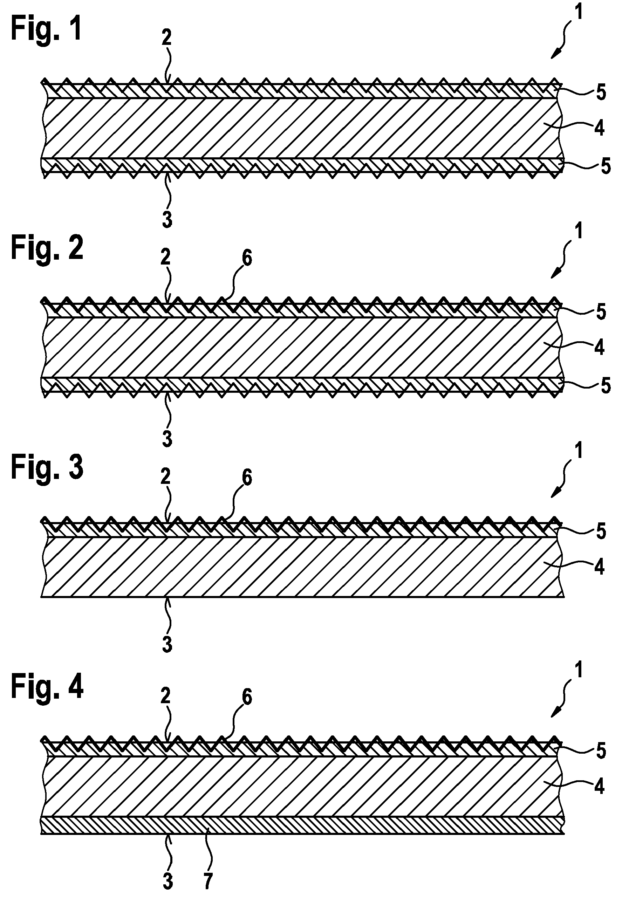

- Fig. 1 - Fig. 14: Querschnittsansichten eines Silizium-Substrats nach verschiedenen Schritten eines erfindungsgemäßen Verfahrens

Bei der nachfolgenden Beschreibung werden für gleiche und gleich wirkende Teile dieselben Bezugsziffern verwendet.

Fig. 1 zeigt eine Querschnittsansicht eines Silizium-Substrats **1,** das als Ausgangs-Silizium-Substrat des erfindungsgemäßen Verfahrens dient. Das Silizium-Substrat **1** weist eine erste Hauptoberfläche **2,** die im Gebrauchszustand als Lichteinfallsseite dient, und eine zweite Hauptoberfläche **3** auf, die als im Gebrauchszustand Rückseite dient. Das Silizium **4** des Silizium-Substrats **1** ist n- oder p-dotiert. Das Silizium **4** des Silizium-Substrats **1** kann monokristallin oder multikristallin sein. Die erste Hauptoberfläche **2** und die zweite Hauptoberfläche **3** wurden sägeschadengeätzt. Darüber hinaus wurde das Silizium-Substrat **1** beidseitig texturiert. In der ersten **2** und zweiten Hauptoberfläche **3** ist eine Phosphor-Dotierschicht **5** angeordnet. Die Phosphor-Dotierschicht **5** wurde beispielsweise durch Diffusion und anschließendem Eintreibschritt erzeugt. Danach wurde das durch die Diffusion und anschließendem Eintreibschritt erzeugte Phosphorsilikatglas von den beiden Hauptoberflächen **2, 3** entfernt.

Fig. 2 zeigt das Silizium-Substrat **1** nach einem ersten Schritt des erfindungsgemäßen Verfahrens. Hierbei wurde einen Antireflexionsschicht oder Antireflexionsschichtfolge **6** auf die erste Hauptoberfläche **2** des Silizium-Substrats **1** aufgebracht, beispielsweise durch Oxidation und/oder PECVD-Verfahren oder andere bekannten Methoden. Die Antireflexionsschicht bzw. Antireflexionsschichtfolge **6** umfasst eine Siliziumnitridschicht und/oder eine Siliziumoxid-Siliziumnitrid-Schichtfolge. Diese dient zusätzlich als Passivierungsschicht der ersten Hauptoberfläche .

Fig. 3 zeigt eine Querschnittansicht des Silizium-Substrats **1** nach einem weiteren optionalen Verfahrensschritt. In dem Verfahrensschritt wird die Phosphor-Dotierschicht **5** der zweiten Hauptoberfläche **3** weggeätzt. Hierdurch wird auch die Texturierung der zweiten Hauptoberfläche **3** geglättet. Vorzugsweise wird hierzu Kalilauge oder HF/HNO₃ verwendet. Falls die Phosphordotierschicht **5** der zweiten Hauptoberfläche **3** nicht entfernt wird, muss die nachfolgende Dotierung mit Aluminium die Phosphor-Dotierung der zweiten Hauptoberfläche **3** überkompensieren. Zudem bleibt ohne diese optionalen Verfahrensschritt die Textur der zweiten Hauptoberfläche **3** erhalten.

Im nächsten Verfahrensschritt wird eine möglichst reine, wenige Mikrometer dünne Aluminiumschicht **7** auf die zweite Hauptoberfläche **3** aufgebracht. Unter einer möglichst reinen Aluminiumschicht **7** ist eine Schicht zu verstehen, die im Wesentlichen nur Aluminium umfasst. Die Aluminium-Dünnschicht **7** wird über die gesamte zweite Hauptoberfläche **3** aufgebracht, beispielsweise durch Aufdampfen oder Sputtern, bis zu einem möglichst geringen Abstand von der Kante des Silizium-Substrats **1.** Der Abstand zur Kante kann auch Null betragen. Fig. 4 zeigt das Silizium-Substrat **1** nach diesem Verfahrensschritt. Die Dicke der Aluminium-Dünnschicht **7** wird hinsichtlich der gewünschten Tiefe der in einem späteren Verfahrensschritt hergestellten Aluminiumdotierschicht **8** gewählt. Die Tiefe der Aluminiumdotierschicht **8** kann zwischen 1 µm und 10 µm liegen. Die Aluminiumdotierschicht **8** fungiert als Emitter bzw. als Back-Surface-Field, je nach Dotierung des Silizium-Substrats **1.**

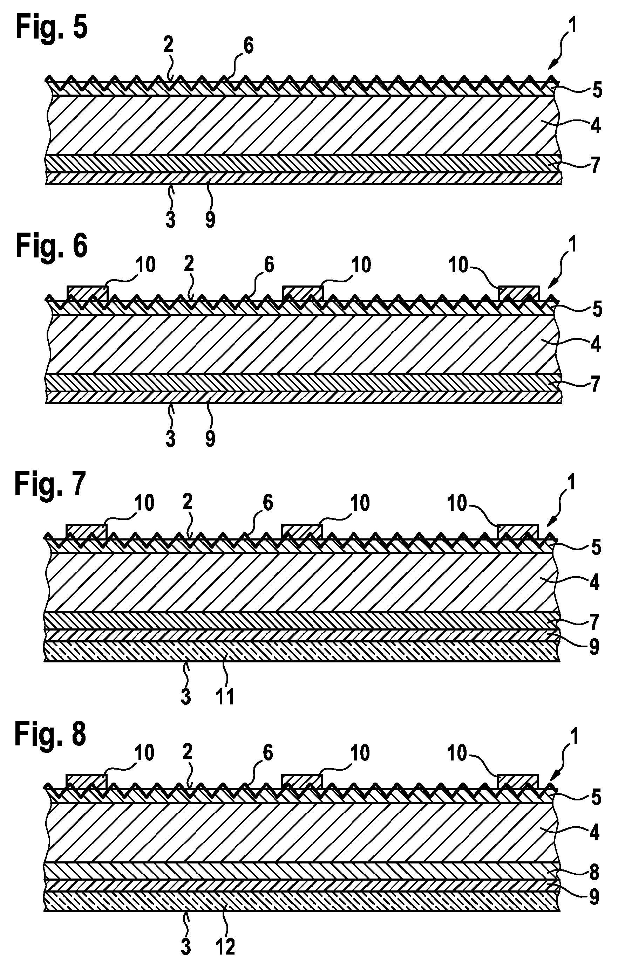

In Fig. 5 ist eine Querschnittsansicht des Silizium-Substrats **1** nach einem weiteren optionalen Verfahrensschritt gezeigt. Die Aluminium-Dünnschicht **7** kann, beispielsweise in der für das Auftragen der Aluminium-Dünnschicht **7** verwendeten Sputter- oder Aufdampf-Anlage, mit einer dünnen dielektrischen Schicht **9,** die vorzugsweise ein Oxid und/oder ein Nitrid umfasst, bedeckt werden. Dadurch wird sichergestellt, dass weitgehend keine Oxidation des Aluminiums der Aluminium-Dünnschicht **7** an Luft stattfindet.

Im nächsten Verfahrensschritt werden auf die erste Hauptoberfläche **2** Metallkontaktbahnen **10,** sogenannte Metallfinger, und optional Sammelschienen, sogenannte Busbars, aufgebracht. Die Breite der Metallkontaktbahnen **10** bzw.

Metallfinger ist möglichst gering. Fig. 6 zeigt eine Querschnittsansicht des Silizium-Substrats **1** nach diesem Aufbringen. Das Aufbringen kann mit einer aus dem Stand der Technik bekannten Methode geschehen. Vorzugsweise werden die Metallkontaktbahnen **10** und die Sammelschienen mit einer Silberpaste gedruckt, mit silberhaltiger Aerosol-Tinte gesprüht oder aus feinen Kanülen extrudiert.

Die erste Hauptoberfläche **2** kann mit einer selektiven Dotierung, d. h. einer Dotierung mit einer höheren Dotierstoffkonzentration und/oder einer tiefer in das Silizium-Substrat **1** hineinreichen Dotierschicht, insbesondere unterhalb den Metallkontaktbahnen und/oder Sammelschienen, versehen werden bzw. eine solche aufweisen.

Fig. 7 zeigt eine Querschnittsansicht eines Silizium-Substrats **1** nach dem nächsten Verfahrensschritt. Bei diesem Verfahrensschritt wird eine dielektrische, glasbildende Paste **11** auf die gesamte zweite Hauptoberfläche **3** aufgebracht und getrocknet. Die Paste **11** deckt die Aluminium-Dünnschicht **7** vollständig ab. Diese Abdeckung der Aluminium-Dünnschicht **7** ist als vorübergehende Abdeckung während des Verfahrens gedacht und wird nach der Dotierung der zweiten Hauptoberfläche **3** mit Aluminium wieder entfernt. Daher wird die Dicke der aufgetragenen Paste **11** möglichst dünn gewählt. Typischerweise beträgt die Dicke 10 µm - 12 µm.

Im nächsten Verfahrensschritt wird die Paste **10** zur Bildung von Metallkontaktbahnen und optionalen Sammelschienen auf der ersten Hauptoberfläche **2** und die glasbildende Paste **11** auf der zweiten Hauptoberfläche **3** gleichzeitig gesintert, vorzugsweise bei Temperaturen oberhalb von 800 °C. Beim Aufheizen oberhalb von 577 °C bilden die Aluminium-Dünnschicht **7** und das Silizium **4** an der zweiten Hauptoberfläche **3** eine flüssige eutektische AlSi-Phase. Fig. 8 zeigt eine Querschnittsansicht des Silizium-Substrats **1** nach diesem Verfahrensschritt. Die Dicke der flüssigen Eutektikumsschicht unter der Glaspaste **11** bzw. Glasabdeckung **12** hängt zu jedem Zeitpunkt von der gerade herrschenden Temperatur und der Dicke der Aluminium-Dünnschicht **7** ab. Nach kurzem Erhitzen oberhalb von 800 °C rekristallisiert beim Abkühlen unter die eutektische Temperatur (ca. 577 °C) die Aluminium-dotierte Kristallschicht von innen nach außen zu einer p⁺-Schicht, die bei einem n-dotierten Silizium-Substrat **1** den Emitter, und bei einem p-dotierten Silizium-Substrat **1** das Back-Surface-Field darstellt. Fig. 8 zeigt eine Querschnittsansicht des Silizium-Substrats **1** nach diesem Verfahrensschritt, in dem eine Aluminium-dotierschicht **8** auf der zweiten Hauptoberfläche **3** entstanden ist. Die Glaspaste 11 bzw. Glasabdeckung **12** verhindert eine Oxidation der flüssigen AlSi-Eutektikumsschicht.

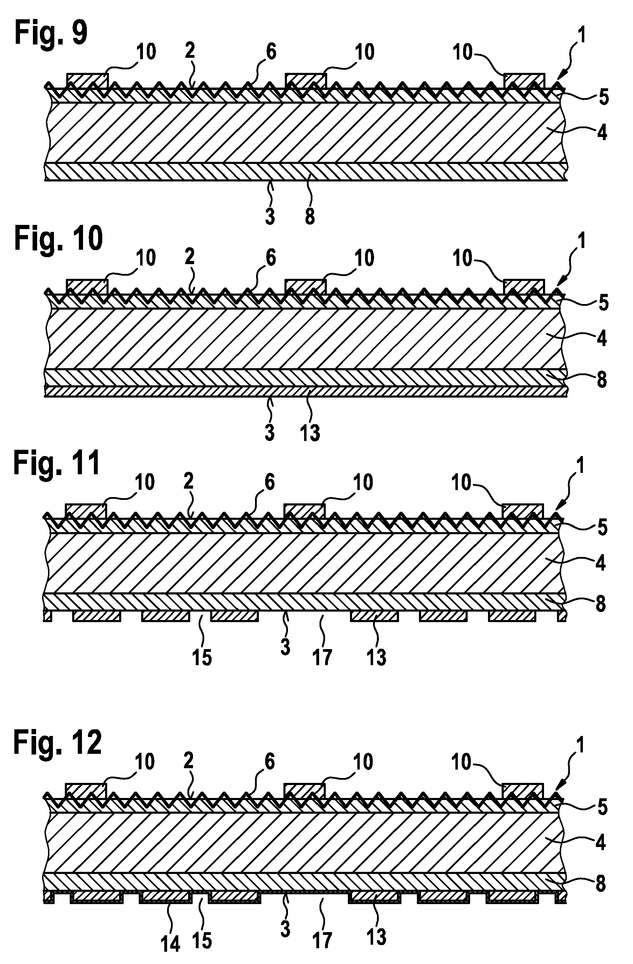

Anschließend erstarrt die restliche eutektische Schmelze in Form der Randphasen des Phasendiagramms zur AlSi-Schicht mit körnigem Gefüge. Nach der Dotierung der zweiten Hauptoberfläche **3** mit Aluminium werden alle Schichten auf der zweiten Hauptoberfläche **3** oberhalb der Aluminiumdotierschicht **8** entfernt. Hierzu werden zunächst mit Flusssäure die dielektrische Schicht **12** und die optionale dielektrische Schicht **9** und anschließend die AlSi- und Aluminium-haltigen Restschichten mit einer geeigneten Säure abgeätzt. Das Silizium-Substrat **1** nach diesem Verfahrensschritt ist in Fig. 9 zu sehen. Die Schichten auf der ersten Hauptoberfläche **2** werden von diesem Ätzvorgang im Wesentlich nicht angegriffen.

Da die Glasschicht nur vorübergehende benötigt wird kann ihre Dicke möglichst dünn gewählt werden, vorzugsweise zwischen 10 µm bis 12 µm. Aufgrund der geringeren Dicke wird weniger Säure benötigt, um diese Schicht wieder aufzulösen bzw. zu entfernen. Im Vergleich zu der Entfernung einer 40 µm dicken Aluminiumschicht bzw. Siebdruck-Aluminiumschicht gemäß dem Stand der Technik, wird wenigstens eine Faktor **4** geringere Menge an Säure, insbesondere Flusssäure, benötigt.

Die nun freiliegende Siliziumoberfläche der zweiten Hauptoberfläche **3,** die mit Aluminium dotiert ist, wird nun mit einer für p⁺-Dotierung geeigneten Passivierungsschicht **13** beschichtet (siehe Fig. 10). Anschließend wird mit einem bekannten Verfahren die Passivierungsschicht **13** lokal geöffnet, beispielsweise durch Laserablation, Ätzpaste und/oder Ionenätzen. Dabei werden auch die Bereiche (Durchbrüche **15** für lokale Kontakte und Lötflächenbereiche **17**) freigelegt, an denen in späteren Verfahrensschritten die lötfähigen Metallflächen (Sammelschienen bzw. Busbars oder Lötkontaktflächen) auf die zweite Hauptoberfläche **3** aufgebracht werden sollen. Das Silizium-Substrat **1** mit der lokal geöffneten Passivierungsschicht **13** ist in Querschnittsansicht in Fig. 11 zu sehen.
Anschließend wird die gesamte zweite Hauptoberfläche **3** mit einem aus dem Stand der Technik bekannten PVD-Verfahren, z. B. durch Sputtern oder Aufdampfen, mit einer weiteren Aluminiumschicht **14** bedeckt. Die weitere Aluminiumschicht **14** ist hinreichend dick und berührt die Aluminiumdotierschicht **8** der zweiten Hauptoberfläche **3** des Silizium-Substrats **1** in den geöffneten Bereichen bzw. Öffnungen **15, 17** direkt und liegt in allen anderen Bereichen der zweiten Hauptoberfläche **3** auf der Passivierungsschicht **13** auf. Fig. 12 zeigt eine Querschnittsansicht des Silizium-Substrats **1** nach diesem Verfahrensschritt. Vorteilhafterweise wird in derselben PVD-Anlage eine dünne nickelhaltige Schicht auf die weitere Aluminiumschicht **14** aufgetragen, um darauf in den Sammelschienen- oder Lötkontaktflächenbereichen später im Verfahren eine lötfähige Schicht in einem chemischen oder galvanischen Prozess einfacher abscheiden zu können.

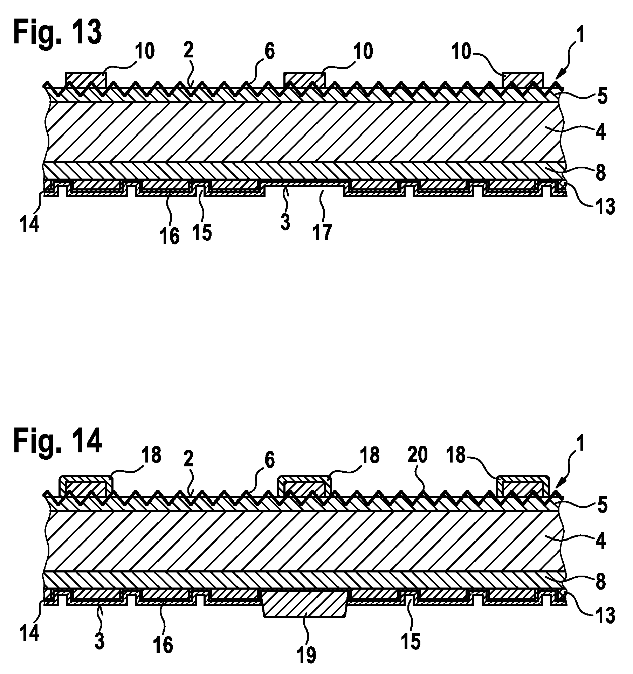

In einem weiteren Verfahrensschritt wird, um die Verstärkung auf die Lötflächenbereiche einzuschränken, in derselben Anlage eine dünne dielektrische bzw. isolierende Schicht **16** auf die gesamte zweite Hauptoberfläche **3** aufgetragen. Anschließend wird diese dielektrische Isolierschicht **16** mit einem der bekannten Verfahren (Laserablation, Ätzpaste, Ionenätzen) in den Lötflächenbereichen zum Bilden von Lötflächenöffnungen **17** geöffnet. Das Silizium-Substrat nach diesem Verfahrensschritt ist in Fig. 13 zu sehen. Hierdurch wird eine nachträgliche chemische und/oder galvanische Verstärkung **18** ausschließlich der Lötflächenöffnungen **17** ermöglicht bzw. erleichtert.

Als letzter Verfahrensschritt werden die Metallkontaktbahnen **10** der ersten Hauptoberfläche **2** und die Lötkontaktflächen **17** der zweiten Hauptoberfläche **3** mit einer lötfähigen Schichtfolge **18, 19** verstärkt. Die lötfähige Schichtfolge **19** besteht aus einer geeigneten Kombination der Metalle Nickel, Silber, Kupfer und/oder Zinn. Das Auftragen der lötfähigen Schichtfolge **19** kann galvanisch oder chemisch vonstatten gehen. Fig. 14 zeigt eine Querschnittsansicht des Silizium-Substrats **1** nach diesem letzten Verfahrensschritt.

An dieser Stelle sei darauf hingewiesen, dass alle oben beschriebenen Schritte des Verfahrens für sich alleine gesehen und in jeder Kombination, insbesondere die in den Zeichnungen dargestellten Details, als erfindungswesentlich beansprucht werden. Abänderungen hiervon sind dem Fachmann geläufig.

Im Übrigen ist die Ausführung der Erfindung nicht auf die oben beschriebenen Beispiele und hervorgehobenen Aspekte beschränkt, sondern lediglich durch den Schutzbereich der anhängenden Patentansprüche.

## Patentansprüche

1. Verfahren zur Herstellung einer Solarzelle aus einem p-dotierten oder n-dotierten Silizium-Substrat (1), das eine Dicke von weniger als 200 µm und eine im Gebrauchszustand als Lichteinfallsseite dienende erste Hauptoberfläche (2) und eine als Rückseite dienende zweite Hauptoberfläche (3) aufweist, folgende Schritte umfassend:
- Aufbringen einer Dünnschicht (7), die Aluminium umfasst, auf die zweite Hauptoberfläche (3),
- Aufbringen und Trocknen einer dielektrischen, glasbildenden Paste (11) auf die aufgebrachte Dünnschicht (7), derart, dass die Aluminium-Dünnschicht (7) von der aufgebrachten Paste (11) vollständig abgedeckt ist,
- Sintern der Paste (11) auf der zweiten Hauptoberfläche (3), insbesondere bei Temperaturen über 577 °C, derart, dass die Dünnschicht (7) mit Silizium aus dem Silizium-Substrat (1) eine flüssige eutektische AlSi-Phase ausbildet und sich aus dieser eine Aluminium-dotierte Schicht (8) in dem Silizium-Substrat (1) an der zweiten Hauptoberfläche (3) ausbildet und
- Entfernen einer bei dem Sintern entstandenen Glasschicht (12) und der bei dem Sintern entstandenen Aluminium-Silizium-Eutetikumsschicht von der zweiten Hauptoberfläche (3), wodurch die Aluminium-Dotierschicht (8) freigelegt wird.

2. Verfahren nach Anspruch 1, wobei das Sintern bei einer Temperatur von mindestens 800 °C abläuft.

3. Verfahren nach einem der vorhergehenden Ansprüche, wobei die Paste (11) mittels Drucken, insbesondere mittels Siebdruck, aufgetragen wird.

4. Verfahren nach einem der vorhergehenden Ansprüche, wobei die Glasschicht (12), insbesondere mittels Flusssäure, und die Aluminium-Silizium-Eutetikumsschicht, insbesondere mittels Salzsäure, von der zweiten Hauptoberfläche (3) weggeätzt werden.

5. Verfahren nach einem der vorhergehenden Ansprüche, wobei ferner Metallkontaktbahnen (10) zum Kontaktieren des Silizium-Substrats (1) und optional Sammelschienen zum elektrischen Verbinden der Metallkontaktbahnen (10) auf die erste Hauptoberfläche (2) aufgebracht werden, wobei während des Sinterns der Paste (11) auf der zweiten Hauptoberfläche (3) gleichzeitig die Metallkontaktbahnen (10) und die optionalen Sammelschienen gesintert werden.

6. Verfahren nach Anspruch 5, wobei die Metallkontaktbahnen und die optionalen Sammelschienen durch Aufdrucken einer Silberpaste und/oder Aufsprühen einer silberhaltigen Aerosol-Tinte und/oder Extrudieren einer Silberpaste aus feinen Kanülen aufgebracht werden.

7. Verfahren nach einem der vorhergehenden Ansprüche, wobei ferner vor dem Aufbringen der Paste (11) auf die zweite Hauptoberfläche (3) eine dünne dielektrische Schicht (9), insbesondere ein Oxid und/oder ein Nitrid umfassend, auf die Dünnschicht (7) zur Vermeidung einer Oxidation des Aluminiums der Dünnschicht (7) an Luft aufgebracht wird.

8. Verfahren nach einem der vorhergehenden Ansprüche, wobei ferner nach dem Freilegen der Aluminium-Dotierschicht (8)
- eine Passivierungsschicht (13) auf die zweite Hauptoberfläche (3) aufgebracht wird,
- die Passivierungsschicht (13) von Bereichen der zweiten Hauptoberfläche (3) zum Bilden von Öffnungen (15, 17) entfernt wird, und
- eine weitere Aluminiumschicht (14), insbesondere durch ein PVD-Verfahren, vorzugsweise Sputtern und/oder Aufdampfen, auf die zweite Hauptoberfläche (3) zum Kontaktieren der Aluminium-dotierten Schicht (8) in den Öffnungen (15, 17) aufgebracht wird.

9. Verfahren nach Anspruch 8, wobei das Entfernen der Passivierungsschicht (13) von Bereichen der zweiten Hauptoberfläche (3) mittels Laserablation, Ätzpaste und/oder Ionenätzen geschieht.

10. Verfahren nach Anspruch 8 oder 9, wobei ferner eine nickelhaltige Grundschicht auf die weitere Aluminiumschicht (14) der zweiten Hauptoberfläche (3) aufgebracht wird zur Ermöglichung einer chemischen und/oder galvanischen Verstärkung (18).

11. Verfahren nach einem der Ansprüche 8-10, wobei ferner nach dem Aufbringen der weiteren Aluminiumschicht (14) und der optionalen nickelhaltigen Schicht auf die zweite Hauptoberfläche (3)
- eine Isolierungsschicht (16) auf die zweite Hauptoberfläche (3) aufgebracht wird, und
- die Isolierungsschicht (16) von Bereichen der zweiten Hauptoberfläche (3) zum erneuten Freilegen der Lötflächen (17), insbesondere mittels Laserablation, Ätzpaste und/oder Ionenätzen, entfernt wird zur Ermöglichung einer nachträglichen chemischen und/oder galvanischen Verstärkung (18) der Lötflächenöffnungen (17).

12. Verfahren nach Anspruch 11, wobei ferner eine lötfähige Schicht oder Schichtfolge, insbesondere Nickel, Silber, Kupfer und/oder Zinn umfassend, auf die Metallkontaktbahnen (10) der ersten Hauptoberfläche (2) und in die Lötflächenöffnungen (17) der zweiten Hauptoberfläche (3) galvanisch und/oder chemisch aufgebracht wird, wobei ferner die Verstärkungsschicht (18) der ersten Hauptoberfläche (2) von der Schicht (1) der zweiten Hauptoberfläche (3) verschieden sein kann.

## Claims

1. Method for producing a solar cell from a P-doped or N-doped silicon substrate (1) that comprises a thickness of less than approximately 200 *µ*m and a first main surface (2) that is used as a light incident face in the state of use and a second main surface (3) that is used as a rear face, said method comprising the following steps:
- applying a thin layer (7) that comprises aluminium to the second main surface (3),
- applying and drying a dielectric, glass-forming paste (11) to the applied thin layer (7) in such a manner that the aluminium thin layer (7) is entirely covered by the paste (11) that is applied.
- sintering the paste (11) on the second main surface (3), in particular at temperatures above 577°C, in such a manner that the thin layer (7) together with silicon from the silicon substrate (1) forms a fluid eutectic AlSi-phase and from said phase forms an aluminium-doped layer (8) in the silicon substrate (1) on the second main surface (3) and
- removing from the second main surface (3) a glass layer (12) that occurs during the sintering procedure and the aluminium silicon eutectic layer that occurs during the sintering procedure, as a result of which the aluminium-doped layer (8) is exposed.

2. Method according to Claim 1, wherein the sintering procedure takes place at a temperature of at least 800°C.

3. Method according to any one of the preceding claims, wherein the paste (11) is applied by means of printing, in particular screen printing.

4. Method according to any one of the preceding claims, wherein the glass layer (12) is removed from the second main surface (3) by etching, in particular by means of hydrofluoric acid, and the aluminium silicon eutectic layer is removed by means of etching, in particular by means of hydrochloric acid.

5. Method according to any one of the preceding claims, wherein moreover metal contact tracks (10) for contacting the silicon substrate (1) and optional busbars for electrically connecting the metal contact tracks (10) are applied to the first main surface (2), wherein when sintering the paste (11) on the second main surface (3), the metal contact tracks (10) and the optional busbars are simultaneously sintered.

6. Method according to Claim 5, wherein the metal contact tracks and the optional busbars are applied by means of printing a silver paste and/or spraying on an aerosol ink that contains silver and/or extruding a silver paste from fine tubes.

7. Method according to any one of the preceding claims, wherein moreover prior to applying the paste (11) to the second main surface (3) a thin dielectric layer (9), in particular comprising an oxide and/or a nitride, is applied to the thin layer (7) so as to avoid an oxidation of the aluminium of the thin layer (7) when coming into contact with air.

8. Method according to any one of the preceding claims, wherein moreover after exposing the aluminium-doped layer (8)
- a passivation layer (13) is applied to the second main surface (3),
- the passivation layer (13) is removed from regions of the second main surface (3) so as to form apertures (15, 17), and
- a further aluminium layer (14) is applied, in particular by means of a PVD method, preferably sputtering and/or evaporation deposition, onto the second main surface (3) so as to contact the aluminium-doped layer (8) in the openings (15, 17).

9. Method according to Claim 8, wherein the passivation layer (13) is removed from regions of the second main surface (3) by means of laser ablation, etching paste and/or ion etching.

10. Method according to Claim 8 or 9, wherein moreover a base layer containing nickel is applied to the further aluminium layer (14) of the second main surface (3) so as to render possible a chemical and/or galvanic reinforcement (18).

11. Method according to any one of the claims 8-10, wherein moreover after applying the further aluminium layer (14) and the optional layer containing nickel to the second main surface (3)
- an insulating layer (16) is applied to the second main surface (3), and
- the insulating layer (16) is removed from regions of the second main surface (3) so as to re-expose the soldering surfaces (17), in particular by means of laser ablation, etching paste and/or ion etching, so as to render possible a subsequent chemical and/or galvanic reinforcement (18) of the soldering surface openings (17).

12. Method according to Claim 11, wherein moreover a layer or a sequence of such a layer that is capable of being soldered, in particular comprising nickel, silver, copper and/or tin, is galvanically and/or chemically applied to the metal contact tracks (10) of the first main surface (2) and into the soldering surface openings (17) of the second main surface (3), wherein moreover the reinforcement layer (18) of the first main surface (2) can differ from the layer (1) of the second main surface (3).

## Revendications

1. Procédé de fabrication d'une cellule solaire à partir d'un substrat de silicium (1) dopé p ou dopé n, qui présente une épaisseur de moins de 200 µm, et une première surface principale (2) servant de côté d'incidence de la lumière à l'état d'utilisation et une deuxième surface principale (3) servant de côté arrière, comprenant les étapes suivantes :
- application sur la deuxième surface principale (3) d'une couche mince (7) qui comprend de l'aluminium,
- application et séchage sur la couche mince appliquée (7) d'une pâte (11) diélectrique formant du verre, de manière à ce que la couche mince en aluminium (7) soit complètement recouverte par la pâte (11) appliquée,
- frittage de la pâte (11) sur la deuxième surface principale (3), notamment à des températures supérieures à 577 °C, de manière à ce que la couche mince (7) forme avec le silicium du substrat de silicium (1) une phase AlSi eutectique liquide et qu'à partir de celle-ci, il se forme sur la deuxième surface principale (3) une couche (8) dopée aluminium dans le substrat de silicium (1), et
- enlèvement de la deuxième surface principale (3) d'une couche de verre (12) produite lors du frittage et de la couche d'eutectique aluminium-silicium produite lors du frittage, sur quoi la couche dopée aluminium (8) est dégagée.

2. Procédé selon la revendication 1, le frittage se déroule à une température d'au moins 800 °C.

3. Procédé selon l'une quelconque des revendications précédentes, dans lequel la pâte (11) est appliquée au moyen d'impression, notamment au moyen de sérigraphie.

4. Procédé selon l'une quelconque des revendications précédentes, dans lequel la couche de verre (12) est enlevée par décapage de la deuxième surface principale (3), notamment au moyen d'acide fluorhydrique, et dans lequel la couche d'eutectique aluminium-silicium est enlevée par décapage de la deuxième surface principale (3), notamment au moyen d'acide chlorhydrique.

5. Procédé selon l'une quelconque des revendications précédentes, dans lequel en outre des voies de contact métalliques (10), destinées à la mise en contact du substrat de silicium (1), et, en option, des barres collectrices destinées à la connexion électrique des voies de contact métalliques (10) sont appliquées sur la première surface principale (2), dans lequel, pendant le frittage de la pâte (11) sur la deuxième surface principale (3), les voies de contact métalliques (10) et les barres collectrices optionnelles sont simultanément frittées.

6. Procédé selon la revendication 5, dans lequel les voies de contact métalliques et les barres collectrices optionnelles sont appliquées par impression d'une pâte d'argent et/ou par pulvérisation d'une encre aérosol contenant de l'argent et/ou par extrusion d'une pâte d'argent à partir de fines canules.

7. Procédé selon l'une quelconque des revendications précédentes, dans lequel en outre, avant l'application de la pâte (11) sur la deuxième surface principale (3), une mince couche (9) diélectrique, notamment contenant un oxyde et/ou un nitrure, est appliquée sur la couche mince (7) pour éviter une oxydation de l'aluminium de la mince couche (7) à l'air.

8. Procédé selon l'une quelconque des revendications précédentes, dans lequel en outre, après le dégagement de la couche dopée aluminium (8),
- une couche de passivation (13) est appliquée sur la deuxième surface principale (3),
- la couche de passivation (13) est enlevée de zones de la deuxième surface principale (3) pour former des orifices (15, 17), et
- une couche d'aluminium supplémentaire (14) est appliquée sur la deuxième surface principale (3), notamment au moyen d'un procédé PVD, de préférence de dépôt par pulvérisation et/ou par vaporisation, pour la mise en contact de la couche dopée aluminium (9) dans les orifices (15, 17).

9. Procédé selon la revendication 8, dans lequel l'enlèvement de la couche de passivation (14) de zones de la deuxième surface principale (3) est réalisé au moyen d'abrasion laser, de pâte mordante et/ou par décapage ionique.

10. Procédé selon la revendication 8 ou 9, dans lequel en outre une couche de base contenant du nickel est appliquée sur la couche d'aluminium supplémentaire (14) de la deuxième surface principale (3) pour permettre un renforcement (1) chimique et/ou galvanique.

11. Procédé selon l'une quelconque des revendications 8 à 10, dans lequel en outre, après l'application de la couche d'aluminium supplémentaire (14) et de la couche optionnelle contenant du nickel sur la deuxième surface principale (3),
- une couche d'isolation (16) est appliquée sur la deuxième surface principale (3), et
- la couche d'isolation (16) est enlevée de zones de la deuxième surface principale (3) pour le dégagement une nouvelle fois des surfaces à souder (17), notamment au moyen d'abrasion laser, de pâte mordante et/ou par décapage ionique, pour permettre un renforcement ultérieur (18) chimique et/ou galvanique des orifices (17) des surfaces à souder (17).

12. Procédé selon la revendication 11, dans lequel en outre une couche soudable ou une suite de couches, comprenant notamment du nickel, de l'argent, du cuivre et/ou de l'étain, est appliquée de manière galvanique et/ou chimique sur les voies de contact métalliques (10) de la première surface principale (2) et dans les orifices (17) des surfaces à souder de la deuxième surface principale (3), dans lequel en outre la couche de renforcement (18) de la première surface principale (2) peut être différentes de la couche (1) de la deuxième surface principale (3).
